# FASCICULE DE BREVET EUROPEEN

(11) **EP 3 589 910 B1**
(45) Date de publication et mention de la délivrance du brevet: **07.04.2021**
(21) Numéro de dépôt: 18708114.6
(22) Date de dépôt: 28.02.2018
(51) Int. Cl.: F41A 19/01, F41A 21/32

(54) **DISPOSITIF DE MESURE DE REGIME DE TIRS SUBIS PAR UN CANON D'UNE ARME**
VORRICHTUNG ZUR MESSUNG DER FEUERGESCHWINDIGKEIT VON DURCH EINEN LAUF EINER WAFFE ABGEGEBENEN SCHÜSSEN
DEVICE FOR MEASURING THE FIRING RATE OF SHOTS FIRED BY A BARREL OF A WEAPON

(30) Priorité: 28.02.2017 BE 201705121
(43) Date de publication de la demande: 08.01.2020
(73) Titulaire: FN Herstal S.A., 4040 Herstal (BE)
(72) Inventeur: LIBOTTE, Hugues, 4845 Jalhay (BE)
(74) Mandataire: Pronovem
(86) Numéro de dépôt international: PCT/EP2018/054945
(87) Numéro de publication internationale: WO 2018/158320

(56) Documents cités:
- US-A1- 2005 114 084
- US-A1- 2017 051 993
- US-B2- 8 290 747

## Description

### Objet de l'invention

La présente invention se rapporte à un dispositif autoalimenté de mesure de régime de tir subis par le canon d'une arme.

La présente invention se rapporte également à tout type de canon comportant ce dispositif.

La présente invention se rapporte en outre à une méthode permettant de mesurer les régimes de tir d'une arme.

### Etat de la technique

L'usure d'une arme et, par là-même, la maintenance à prévoir, dépend notamment du régime de tir. Le régime de tir est la quantité de tirs réalisés par l'utilisateur sur un intervalle de temps donné. Dès lors, le régime représente l'intensité de l'utilisation de l'arme, et de ce fait, l'échauffement du canon. Cet échauffement est lui-même représentatif de l'usure induite de l'arme et du canon.

Actuellement, les mesures de régime sont réalisées par des dispositifs situés dans la carcasse de l'arme, et n'étant pas liés au canon. Il serait pourtant intéressant d'avoir un dispositif permettant de mesurer le régime de tir situé sur le canon lui-même. En effet, le canon des mitrailleuses, par exemple, sont interchangeables, ce qui induit la nécessité de faire une mesure du régime directement associée à leurs canons. Une mesure du nombre de coups tirés et des intervalles de temps associés au niveau de la carcasse de l'arme ne peut, sauf association avec l'identification du canon, permettre de savoir ce que tel ou tel canon a déjà subi. Une telle association ne peut se faire facilement. En effet, la procédure de remplacement du canon ainsi que les conditions environnementales, souvent compliquées, permettent difficilement d'intégrer une connectique particulière entre celui-ci et le corps de la mitrailleuse. De plus, on ne peut pas demander à l'utilisateur, en particulier en situation de stress, d'identifier le canon dans le système de comptage

Par ailleurs, l'utilisation de récupérateurs d'énergie pour alimenter le dispositif de mesure est très utile. En effet, malgré que les piles permettent d'atteindre plusieurs dizaines d'années de durée de vie, leur vieillissement est difficile à prévoir. Néanmoins, la mesure du régime de tir par un dispositif ne possédant pas de pile est délicate, étant donné qu'il est nécessaire d'avoir assez d'énergie entre deux coups successifs pour alimenter le dispositif de mesure. Les temps entre deux événements sont longs et imprévisibles. Ceci n'est pas évident surtout en considérant les contraintes environnementales fortes propres au milieu armurier (militaire et civil).

Il existe déjà des dispositifs de mesure de régime avec récupération d'énergie, mais ceux-ci sont alimentés grâce au compteur de coups situé dans le corps de l'arme. Vu que le canon est détachable du reste de l'arme, il sera difficilement possible de faire communiquer de façon fiable et ergonomique, avec ou sans fil, le compteur de coup situé sur le corps de l'arme avec un système de mesure de régime au niveau du canon. Dès lors, il faut que ce système de mesure soit autoalimenté.

L'invention a donc pour but de fournir un dispositif électronique, autoalimenté, de mesure du régime d'un canon d'une arme.

Différents documents concernant la récupération d'énergie des tirs existent, mais ceux-ci concernent les dispositifs permettant de compter les coups, et non pas le régime de l'arme, et sont localisés dans la carcasse de l'arme. Le document WO 2016142444 A1 présente un dispositif de comptage de coup d'une arme afin de connaitre son usure. Ce dispositif permet grâce à un circuit électronique et un capteur de mouvement de détecter le nombre et le type de coups tirés. Le circuit électrique peut être alimenté par récupération d'énergie.

Les dispositifs de récupération d'énergie utilisés pour le comptage des coups ne sont généralement pas adaptés à la mesure du régime.

Le document EP 2 573 498 divulgue un générateur d'énergie électrique qui transforme l'énergie mécanique à partir d'un coup de feu en courant électrique pour alimenter le compteur de tir d'une arme à feu. Les mouvements (mécaniques, vibratoires,...) ou d'autres phénomènes (thermique, acoustique,...) lors du tir sont transformés en signal électrique, qui sera par la suite fourni au compteur de tir situé dans la carcasse de l'arme.

Le document US 8,290,747 divulgue un système électronique destiné à enregistrer un événement grâce à un capteur qui fournit de l'énergie mécanique à une structure comprenant une mémoire électronique. Toute l'énergie pour détecter l'événement et l'enregistrement de l'événement dans la mémoire électronique est dérivée de l'énergie mécanique. Ce document décrit aussi un dispositif comprenant un transducteur piézoélectrique et une mémoire. Un signal provenant du transducteur piézo-électrique (qui dépasse un certain seuil) va permettre de changer l'état de la mémoire. Toute l'énergie pour changer l'état de la mémoire est dérivée de ce signal.

Le document US2005/0114084 A divulgue un dispositif de mesure de régime de tir déterminé à partir de la température du canon en fonction du temps. Néanmoins, ce dispositif n'est pas autoalimenté.

### Buts de l'invention

La présente invention a pour but de réaliser un dispositif apte à mesurer les régimes de tir d'une arme, grâce à un réseau électrique passif.

Grâce au dispositif de l'invention, le régime de tir subis par le canon va pouvoir être calculé, sans avoir besoin d'un apport d'énergie externe, tel que par exemple une pile ou une batterie.

Un tel dispositif selon l'invention permet un contrôle permanent et spécifique du canon d'une arme et veille à la sécurité de celle-ci grâce à une maintenance améliorée. En effet, ce dispositif permet de mesurer l'échauffement du canon et donc d'évaluer l'usure de celui-ci grâce au calcul du régime de tir de l'arme.

### Résumé de l'invention

La présente invention se rapporte à un dispositif autoalimenté de mesure de régime de tir pour tout type de canon d'arme, en particulier d'arme à feu, comprenant:
- un générateur thermoélectrique convertissant la différence de température entre ledit canon et la température ambiante en énergie électrique ;
- un système apte à calculer et/ou mesurer la température du canon ;
- un système de traitement et d'enregistrement desdites mesures;
le système de prise de mesure et le système de traitement et d'enregistrement des mesures étant alimentés par le générateur thermoélectrique, et le régime de tir étant déterminé à partir de la mesure ou de l'évaluation de la température du canon en fonction du temps, le générateur thermoélectrique étant une cellule Seebeck générant de l'électricité grâce à la différence de température entre l'air ambiant et le canon.

Selon des modes particuliers de l'invention, le dispositif comporte au moins une ou une combinaison appropriée des caractéristiques suivantes :
- le système calculant la température du canon est plus précisément un système mesurant la tension générée par la cellule Seebeck et estimant la température à partir de cette tension;
- le système apte à calculer la température du canon est une sonde de température alimentée par le générateur thermoélectrique ;
- le système apte à calculer la température du canon est plus précisément une sonde optique de température ou une sonde résistive;
- une isolation thermique est comprise pour protéger le dispositif de la chaleur du canon de l'arme ;
- le système d'enregistrement est une mémoire interne pouvant être lue par un système de lecture externe;
- le dispositif comprend un système de gestion de l'alimentation ;
- le dispositif comprend un élément radiateur du côté de la face froide de la cellule Seebeck;
- le système de lecture est alimenté par induction ;
- le système de lecture est alimenté par radiofréquence.

La présente invention se rapporte également à un canon d'arme comportant un dispositif de mesure tel que décrit ci-dessus.

La présente invention se rapporte également à une arme comportant, dans son canon, un dispositif de mesure tel que décrit ci-dessus.

La présente invention se rapporte en outre à une méthode de mesure de régime de tir pour tout type de canon à l'aide d'un dispositif selon la revendication 1, comprenant les étapes suivantes :
- récupération de l'énergie provenant de la chaleur du canon ;
- transformation de ladite énergie thermique en énergie électrique ;
- alimentation, par ladite énergie électrique, du système apte à calculer la température du canon et du système de traitement et d'enregistrement des mesures;
- détermination du régime de tir à l'aide de la température du canon enregistrée en fonction du temps.

Selon un mode de réalisation préféré de l'invention, la méthode de mesure comprend une étape additionnelle de lecture des mesures enregistrées par un système de lecture.

Avantageusement, la méthode de l'invention comprend une étape de gestion de l'alimentation électrique des systèmes par l'énergie électrique générée.

### Brève description des figures

La figure 1 représente un diagramme des éléments compris dans le dispositif.
La figure 2 représente une vue d'une coupe transversale d'une réalisation du dispositif sur le canon.

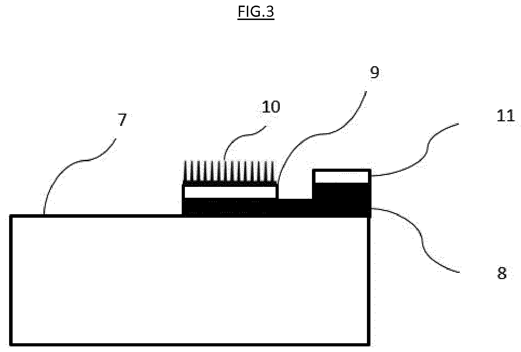

La figure 3 représente une vue d'une coupe longitudinale d'une réalisation du dispositif sur le canon.

### Description détaillée de l'invention

Le dispositif selon l'invention mesure le régime de tir d'un canon d'une arme. Ce dispositif est adaptable à tout type de canons de tout type d'armes à feu, (fusil, pistolet, mitrailleuse, pistolet mitrailleur), automatique, semi-automatique ou à alimentation manuelle.

Afin d'estimer le vieillissement du canon, grâce à la mesure du régime de tir, l'historique de la température de celui-ci est analysé. Le dispositif de l'invention est autoalimenté au moyen d'un générateur thermoélectrique utilisant l'échauffement du canon comme source d'énergie, pour éviter les inconvénients liés à l'utilisation d'une pile.

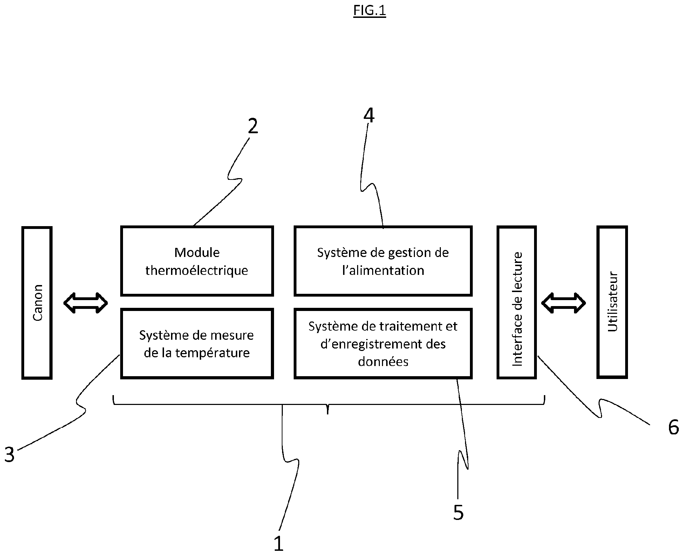

Le dispositif 1, comme représenté sur la Figure 1, comprend un générateur thermoélectrique 2 apte à récupérer de la chaleur du tir pour générer de l'électricité et alimenter tous les autres composants inclus dans le dispositif 1 et consommant de l'énergie.

En outre, le dispositif 1 comprend un système 3 permettant de calculer/mesurer la température du canon 7, ce système étant alimenté par le générateur thermoélectrique 2. Les mesures de l'échauffement du canon 7 et de la durée associée à cet échauffement sont réalisées par ce système 3 au moyen d'une électronique ne consommant que très peu d'énergie. Les mesures sont stockées de façon non-volatile dans un système de traitement et d'enregistrement des données 5 compris dans le dispositif 1 de l'invention.

Par ailleurs, le dispositif de mesure du régime peut comprendre un module de gestion de l'alimentation 4.

Il est bien entendu que la mesure de régime de tir ne sera faite que lorsque la température du canon sera suffisante pour alimenter le système. En effet, pour des régimes faibles, lorsque le canon ne dépasse pas une valeur seuil au-dessus de la température ambiante, il est impossible de tenir compte de ces tirs dans la maintenance du canon.

Le calcul ou l'estimation du régime de tir résulte de l'enregistrement de la température en fonction du temps. Après traitement et enregistrement des données par le système 5, l'utilisateur peut à tout moment venir relire le contenu de la mémoire. Ce système de lecture doit amener au travers de l'interface de lecture 6 l'énergie nécessaire au fonctionnement du module 5. Ceci peut se faire, par exemple, au moyen d'un système alimenté par induction, ou d'une technologie RFID (LF, HF ou UHF) ou d'alimentation sans fil couplée à un moyen de communication par radiofréquence plus traditionnel.

Le processus d'analyse des courbes pourra être réalisé dans le système embarqué ou externalisé vers une unité extérieure au système de mesure.

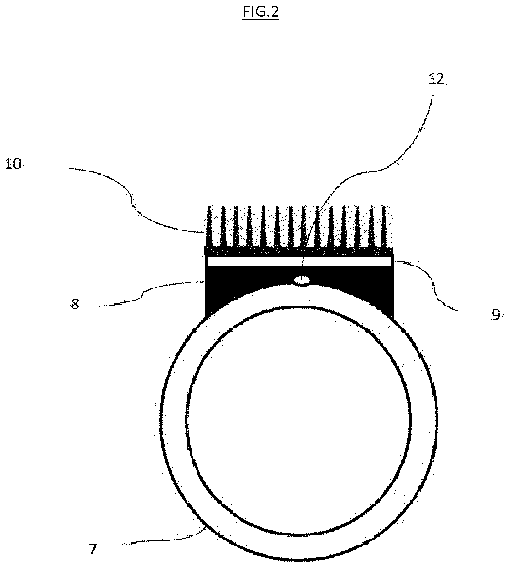

Dans une application particulière de l'invention, le générateur thermoélectrique 2 est une cellule Seebeck 9, comme représenté à la Figure 2. Cette cellule est bien connue de l'art antérieur et permet, grâce à une différence de température entre ses deux jonctions d'induire une différence de potentiel électrique permettant d'alimenter un circuit en courant électrique. La source chaude de la cellule 9 est constituée par le canon 7 de l'arme tandis que la source froide est l'air ambiant. Pour améliorer le différentiel de température entre l'air ambiant et la face froide de la cellule 9, il est nécessaire d'adjoindre au dispositif un élément radiateur 10.

Ce radiateur se situe près de la face froide de la cellule pour limiter le différentiel de température entre cette face et l'air libre. En effet, il faut assurer un échange thermique entre la face froide de la cellule thermoélectrique et l'atmosphère sous peine de voir le rendement global rapidement s'effondrer. La forme physique du radiateur 10 répond aux contraintes de réduction de la résistance thermique mais aussi de tenue mécanique aux conditions d'utilisation assez rudes propres aux produits armuriers militaires et civils.

Au vu des températures élevées que le canon peut atteindre, une barrière isolante 8 est prévue pour protéger la cellule Seebeck 9. D'ailleurs, une isolation thermique est aussi comprise pour protéger le dispositif 1 de la chaleur du canon, et par là même, tous les composants de ce dispositif (le système 3 apte à calculer la température du canon, le générateur thermoélectrique 2, le système de traitement et d'enregistrement des données 5, le module de gestion de l'alimentation 4, l'interface de lecture 6). En effet, la température du canon peut atteindre 600°C, ce qui implique que les éléments du dispositif doivent être protégés d'un contact direct avec le canon pour éviter leur destruction en cours de fonctionnement.

Cette barrière isolante doit être suffisante pour empêcher la dégradation physique de l'électronique et de la cellule thermoélectrique, mais suffisamment faible pour ne pas dégrader les performances du générateur thermoélectrique.

Selon une réalisation particulière de l'invention, le système apte à calculer de la température du canon est un dispositif mesurant directement la tension générée par la cellule Seebeck. Dans cette configuration, la température est calculée sur base de cette tension signal sortant directement du module thermoélectrique.

Dans une application particulière de l'invention, comme représenté à la Figure 2, le système pour calculer de la température du canon est une sonde de température 12, relevant la température du canon par contact avec celui-ci. La sonde est capable de supporter une température de l'ordre de 600°C (grâce à un thermocouple, par exemple).

Selon une autre application particulière de l'invention, la température du canon est mesurée à l'aide d'une sonde optique de température, munie d'une protection adéquate.

Le système de gestion de l'alimentation peut également être pourvu d'une protection contre l'inversion de la tension, par exemple, en cas de trempe du canon dans un liquide pour en accélérer le refroidissement, ...

Le système constitué par les éléments 2 et 4 peut être utilisé pour d'autres applications nécessitant de l'énergie sur le canon d'une arme.

## Revendications

1. Dispositif autoalimenté de mesure de régime de tir pour tout type de canon d'arme, comprenant:
a) un générateur thermoélectrique (2) convertissant de l'énergie thermique à partir de la différence de température entre ledit canon (7) et la température ambiante en énergie électrique ;
b) un système (3) apte à déterminer la température du canon (7) ;
c) un système de traitement et d'enregistrement desdites mesures (4);
d) le système de détermination de température (3) et le système de traitement et d'enregistrement des mesures (4) étant alimentés par le générateur thermoélectrique (2), et, en utilisation, le régime de tir étant déterminé à partir de la température du canon en fonction du temps, le générateur thermoélectrique étant une cellule Seebeck (9) générant de l'électricité grâce à la différence de température entre l'air ambiant et le canon.

2. Dispositif selon la revendication 1 dans lequel le dispositif comprend un élément radiateur (10) du côté de la face froide de la cellule Seebeck.

3. Dispositif selon l'une des revendications précédentes dans lequel le système calculant la température du canon est un système mesurant la tension générée par la cellule Seebeck (9) et estimant la température à partir de cette tension.

4. Dispositif la revendication 1 ou 2 dans lequel le système apte à calculer la température du canon (7) comprend une sonde de température alimentée par le générateur thermoélectrique.

5. Dispositif selon la revendication 4 dans lequel le système apte à calculer la température du canon comprend une sonde optique ou une sonde résistive.

6. Dispositif selon l'une des revendications précédentes dans lequel une isolation thermique (8) est comprise entre le canon (7) et l'électronique du dispositif pour la protéger de la chaleur du canon de l'arme.

7. Dispositif selon l'une des revendications précédentes dans lequel le système d'enregistrement est une mémoire interne pouvant être lue par un système de lecture externe.

8. Dispositif selon la revendication 7 dans lequel le système de lecture est alimenté par induction radiofréquence tel qu'un module RFID.

9. Canon comprenant un dispositif selon l'une des revendications précédentes.

10. Méthode de mesure de régime de tir pour canon à l'aide d'un dispositif selon la revendication 1, comprenant les étapes suivantes :
i. récupération de l'énergie provenant de la chaleur du canon ;
ii. transformation de ladite énergie thermique en énergie électrique ;
iii. alimentation, par ladite énergie, du système apte à calculer la température du canon et du système de traitement et d'enregistrement des mesures;
iv. détermination du régime de tir à l'aide de la température du canon enregistrée en fonction du temps.

11. Méthode selon la revendication 10 dans laquelle la méthode de mesure comprend une étape additionnelle de lecture des mesures enregistrées par un système de lecture externe.

12. Méthode selon la revendication 11 dans laquelle le système de mesure externe est un système de lecture sans contact.

13. Méthode selon la revendication 12 dans laquelle le système de mesure externe est un système de lecture RFID.

## Patentansprüche

1. Vorrichtung zur Messung der Schießgeschwindigkeit mit eigener Stromversorgung für Gewehrläufe jeglicher Art, umfassend:
a) einen thermoelektrischen Generator (2), der Wärmeenergie aufgrund des Temperaturunterschieds zwischen dem besagten Lauf (7) und der Umgebungstemperatur in elektrische Energie umwandelt;
b) ein System (3), das zur Ermittlung der Temperatur des Laufs (7) geeignet ist;
c) ein System (4) zur Verarbeitung und Aufzeichnung dieser besagten Messwerte;
d) wobei das System (3) zur Ermittlung der Temperatur und das System (4) zur Verarbeitung und Aufzeichnung der Messwerte vom thermoelektrischen Generator (2) mit Energie versorgt werden und
wobei im Einsatz die Schießgeschwindigkeit anhand der Lauftemperatur als Funktion der Zeit ermittelt wird, wobei der thermoelektrische Generator eine Seebeck-Zelle (9) ist, die aufgrund des Temperaturunterschieds zwischen der Umgebungsluft und dem Lauf Strom erzeugt.

2. Vorrichtung nach Anspruch 1
wobei die Vorrichtung ein Radiatorelement (10) an der Seite der kalten Oberfläche der Seebeck-Zelle umfasst.

3. Vorrichtung nach einem der vorstehenden Ansprüche, wobei das System, das die Lauftemperatur berechnet, ein System ist, das die von der Seebeck-Zelle (9) erzeugte Spannung misst und anhand dieser Spannung die Temperatur abschätzt.

4. Vorrichtung nach Anspruch 1 oder 2, wobei das zur Berechnung der Temperatur des Laufs (7) geeignete System einen Temperaturfühler umfasst, der vom thermoelektrischen Generator mit Energie versorgt wird.

5. Vorrichtung nach Anspruch 4, wobei das zur Berechnung der Lauftemperatur geeignete System eine optische Sonde oder eine ohmsche Sonde umfasst.

6. Vorrichtung nach einem der vorstehenden Ansprüche, wobei eine Wärmedämmung (8) zwischen dem Lauf (7) und den elektronischen Komponenten der Vorrichtung angeordnet ist, um diese vor der Wärme des Laufs zu schützen.

7. Vorrichtung nach einem der vorstehenden Ansprüche, wobei das Aufzeichnungssystem ein interner Speicher ist, der von einem externen Lesesystem abgelesen werden kann.

8. Vorrichtung nach Anspruch 7, wobei das Lesesystem durch Radiofrequenzinduktion, z.B. ein RFID-Modul, mit Energie versorgt wird.

9. Lauf, umfassend eine Vorrichtung nach einem der vorstehenden Ansprüche.

10. Verfahren zum Messen der Schießgeschwindigkeit eines Laufs mithilfe einer Vorrichtung nach Anspruch 1, umfassend die Schritte:
i. Zurückgewinnen der von der Wärme des Laufs herrührenden Energie;
ii. Umwandeln der besagten Wärmeenergie in elektrische Energie;
iii. Versorgen des zur Berechnung der Lauftemperatur geeigneten Systems und des Systems zur Verarbeitung und Aufzeichnung der Messwerte mit der besagten Energie;
iv. Ermitteln der Schießgeschwindigkeit anhand der aufgezeichneten Lauftemperatur als Funktion der Zeit.

11. Verfahren nach Anspruch 10, wobei das Messverfahren einen zusätzlichen Schritt des Ablesens der aufgezeichneten Messwerte durch ein externes Lesesystem umfasst.

12. Verfahren nach Anspruch 11, wobei das externe Messsystem ein kontaktloses Lesesystem ist.

13. Verfahren nach Anspruch 12, wobei das externe Messsystem ein RFID-Lesesystem ist.

## Claims

1. Self-powered device for firing rate measuring for any type of weapon barrel, comprising:
a) a thermoelectric generator (2) converting thermal energy from the difference in temperature between said barrel (7) and the ambient temperature into electrical energy;
b) a system (3) able to determine the temperature of the barrel (7);
c) a system for processing and recording said measurements (4);
d) the temperature determining system (3) and the system for processing and recording measurements (4) being powered by the thermoelectric generator (2), and, during use, the firing rate being determined from the temperature of the barrel as a function of time, the thermoelectric generator being a Seebeck cell (9) generating electricity owing to the temperature difference between the ambient air and the barrel.

2. Device according to claim 1, wherein the device comprises a radiator element (10) on the cold-face side of the Seebeck cell.

3. Device according to one of the preceding claims, wherein the system calculating the temperature of the barrel is a system measuring the voltage generated by the Seebeck cell (9) and estimating the temperature from this voltage.

4. Device according to claim 1 or 2, wherein the system able to calculate the temperature of the barrel (7) comprises a temperature probe powered by the thermoelectric generator.

5. Device according to claim 4, wherein the system able to calculate the temperature of the barrel comprises an optical probe or a resistive probe.

6. Device according to one of the preceding claims, wherein thermal insulation (8) is comprised between the barrel (7) and the electronics of the device to protect it from the heat of the barrel of the weapon.

7. Device according to one of the preceding claims, wherein the recording system is an internal memory that can be read by an external reading system.

8. Device according to claim 7, wherein the reading system is powered by radiofrequency induction, such as an RFID module.

9. Barrel comprising a device according to one of the preceding claims.

10. Method for firing rate measuring for a barrel using a device according to claim 1, comprising the following steps:
i. recovering the energy coming from the heat of the barrel;
ii. transforming said thermal energy into electrical energy;
iii. using said energy to power the system able to calculate the temperature of the barrel and of the system for processing and recording measurements;
iv. determining the firing rate using the recorded temperature of the barrel as a function of time.

11. Method according to claim 10, wherein the measuring method comprises an additional step for reading the measurements recorded by an external reading system.

12. Method according to claim 11, wherein the external measuring system is a contactless reading system.

13. Method according to claim 12, wherein the external measuring system is an RFID reading system.
